Europäisches Patentamt

European Patent Office

Office européen des brevets

(19)

(11) Veröffentlichungsnummer : **0 043 350**
**B1**

(12) # EUROPÄISCHE PATENTSCHRIFT

(45) Veröffentlichungstag der Patentschrift :
24.04.85

(21) Anmeldenummer : 81810262.6

(22) Anmeldetag : 25.06.81

(51) Int. Cl.⁴ : **H 03 K 17/97**

(54) **Kontaktlose Tastatur.**

(30) Priorität : 26.06.80 CH 4897/80

(43) Veröffentlichungstag der Anmeldung :
06.01.82 Patentblatt 82/01

(45) Bekanntmachung des Hinweises auf die Patenterteilung : 24.04.85 Patentblatt 85/17

(84) Benannte Vertragsstaaten :
**AT BE CH DE FR GB IT LI NL SE**

(56) Entgegenhaltungen :
DE-A- 1 928 294
DE-A- 2 152 209
DE-B- 2 408 000
US-A- 3 668 697
US-A- 3 683 371
US-A- 3 836 910

(73) Patentinhaber : **STANDARD TELEPHON UND RADIO
AG
Friesenbergstrasse 75
CH-8055 Zürich (CH)
CH LI
International Standard Electric Corporation
320 Park Avenue
New York New York 10022 (US)
BE DE FR GB IT NL SE AT**

(72) Erfinder : **Rometsch, Johannes
Sandweidstrasse
CH-5635 Rickenbach (CH)**
Erfinder : **Frey, Werner U.
Dorfstrasse 96
CH-8800 Thalwil (CH)**
Erfinder : **Diem, Hans
Paulistrasse 2
CH-8834 Schindellegi (CH)**

(74) Vertreter : **Bucher, Hans F.
Laupenstrasse 15
CH-3008 Bern (CH)**

**Beschreibung**

Die vorliegende Erfindung betrifft eine kontaktlose Tastatur gemäss dem Oberbegriff des ersten Anspruches.

Es ist bekannt, für kontaktlose Tastaturen induktive Elemente, z. B. Uebertrager, zu verwenden und die Kopplung zwischen Primär- und Sekundärwicklung durch Einschieben eines Kernes bei Betätigung einer Taste zu erhöhen. Ferner ist es bekannt, die aus der Kopplung zwischen Primär- und Sekundärwicklung bei unbetätigter Taste resultierende Leerlaufspannung durch einen weitern, g' ichartigen und keiner Taste zugeordneten U ⌐ertrager mit in einer Wicklung entgegengesetztem Wicklungssinn zu kompensieren, um einen maximalen Pegelunterschied zwischen unbetätigter und betätigter Taste zu erhalten.

Aus dem CH-Patent Nr. 579 799 ist eine kontaktlose Tastatur der obigen Art bekannt, bei welcher ein matrixförmiges Tastenfeld abgefragt wird, wobei ein einzelner Abfrageimpuls bei gedrückter Taste an die Auswerteschaltung gelangt, wo er verstärkt und detektiert wird.

Aus dem GB-Patent Nr. 1 315 885 ist eine kontaktlose Tastatur mit paarweise zusammengeschalteten Impulsübertragern bekannt, bei welcher die Kompensation der Leerlaufspannung jeweils innerhalb eines Tastenpaares erfolgt.

Allen bekannten kontaktlosen Tastaturen mit induktiver oder kapazitiver Ankopplung eines Ansteuersignales an eine Auswerteschaltung ist gemeinsam, dass in der Auswerteschaltung die Amplitude des Tastenausgangssignales ausgewertet wird, um festzustellen, ob eine bestimmte Taste betätigt ist oder nicht. Die Amplitude des auszuwertenden Signales muss also mit einer Bezugsamplitude verglichen werden, deren Wert mit Sicherheit oberhalb des bei unbetätigter Taste vorhandenen Leerlaufsignales liegen muss, welches daher möglichst klein gemacht werden muss, da die bei betätigter Taste erreichbare Amplitude ebenfalls begrenzt ist. Die obigen Umstände führen daher zu einem relativ bescheidenen Störspannungsabstand und bedingen recht hohe Anforderungen bezüglich zeitlicher Konstanz der für die « Kontaktgabe » und die Auswertung verwendeten Elemente.

Es ist nun Aufgabe der Erfindung, eine kontaktlose Tastatur mit induktiver Kopplung anzugeben, bei welcher statt der Amplitude die Phase des Ausgangssignales der Tastenmatrix als Kriterium für die Auswertung verwendet wird. Weiter soll die Tastatur eine einfache Möglichkeit zur Verstellung der Ansprechempfindlichkeit dieser Tastatur aufweisen.

Gelöst wird diese Aufgabe durch die im Kennzeichen des ersten Anspruchs genannten Merkmale. Vorteilhafte Weiterbildungen der Erfindung können den weitern Ansprüchen entnommen werden.

Ein Ausführungsbeispiel der Erfindung wird nun anhand der Zeichnung näher erläutert. In der Zeichnung zeigt :

Die Figur 1 das Prinzipschema einer Tastatur mit Transformatoren ;

Die Figur 2 ein Blockschema einer Tastatur mit 32 Tasten ; und

Die Figur 3 ein Impulsdiagramm mit Signalen an verschiedenen Punkten der Schaltung nach Fig. 2.

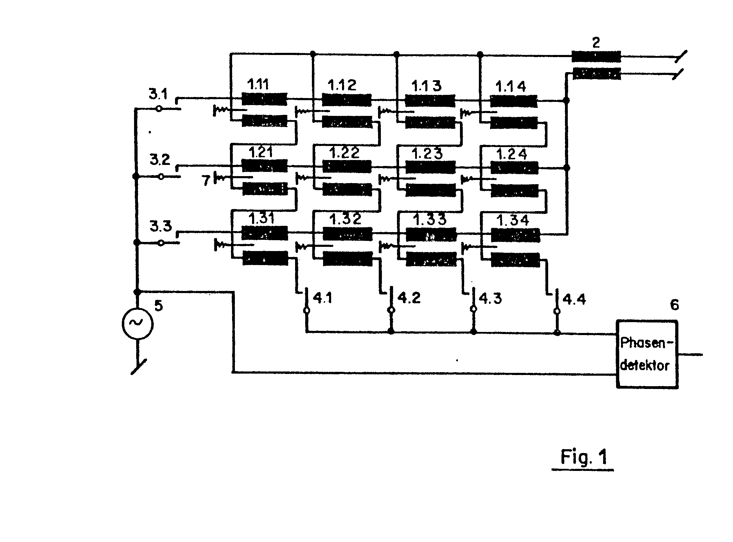

Bei der Tastatur nach Fig. 1 sind 12 Transformatoren 1 vorhanden, die je einen verschiebbaren Kern 7 aufweisen. Die Primärwicklungen einer Zeile von Tastentransformatoren sind unter sich in Reihe geschaltet und über einen als Kontakt dargestellten Schalter 3 an einen Generator 5 anschaltbar. Die Sekundärwicklungen von jeweils einer Kolonne sind ebenfalls unter sich in Reihe geschaltet und über einen Schalter 4 an einen Phasendetektor 6 anschaltbar. Die nichtgeschalteten Enden aller Serieschaltungen von Primärwicklungen sind mit der Primärwicklung eines Kompensationstransformators 2 in Reihe geschaltet, während dessen Sekundärwicklung mit den ungeschalteten Enden aller Serieschaltungen von Sekundärwicklungen in Reihe geschaltet ist.

Für die Abfrage der Tastatur wird z. B. Zeilenschalter 3.1 geschlossen und durch aufeinanderfolgendes Schliessen der Schalter 4 wird jede Kolonne einzeln abgefragt. Anschliessend wird Schalter 3.2 geschlossen und die gleiche Kolonnenabfrage wiederholt, usw. Es wird also zu einem bestimmten Zeitpunkt immer nur einer der Tastentransformatoren aktiv geschaltet, zu dem aber immer der Kompensationstransformator in Reihe geschaltet ist.

Im Gegensatz zu den bekannten Schaltungen ist der Kompensationstransformator 2 hier jedoch nicht so ausgelegt, dass er die bei unbetätigter Taste, d. h. bei nicht eingeschobenem Kern, infolge Luftinduktion auftretende Leerlaufspannung auf eine Amplitude nahe Null kompensiert, sondern derart, dass eine Ueberkompensation auftritt. Dies bedeutet, dass sich das an die Auswerteschaltung gelangende Sekundärsignal aus zwei Komponenten zusammensetzt, nämlich aus der Sekundärspannung des Kompensationstransformators und aus der Sekundärspannung des gerade angeschalteten Tastentransformators. Bei unbetätigter Taste überwiegt die Komponente des Kompensationstransformators, während bei betätigter Taste jene des Tastentransformators überwiegt. Da die beiden Komponenten auslegungsgemäss gegenphasig sind, kann das Feststellen einer Tastenbetätigung durch einen Phasenvergleich zwischen dem Tastenausgangssignal und dem Generatorsignal durchgeführt werden, was im Phasendetektor 6 geschieht.

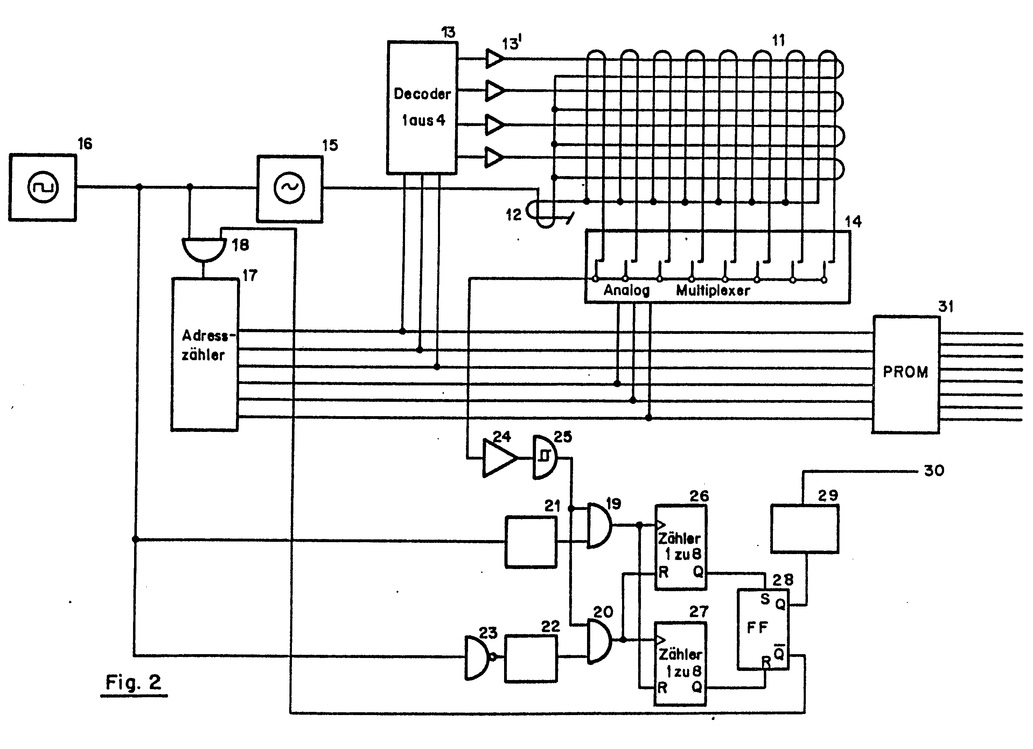

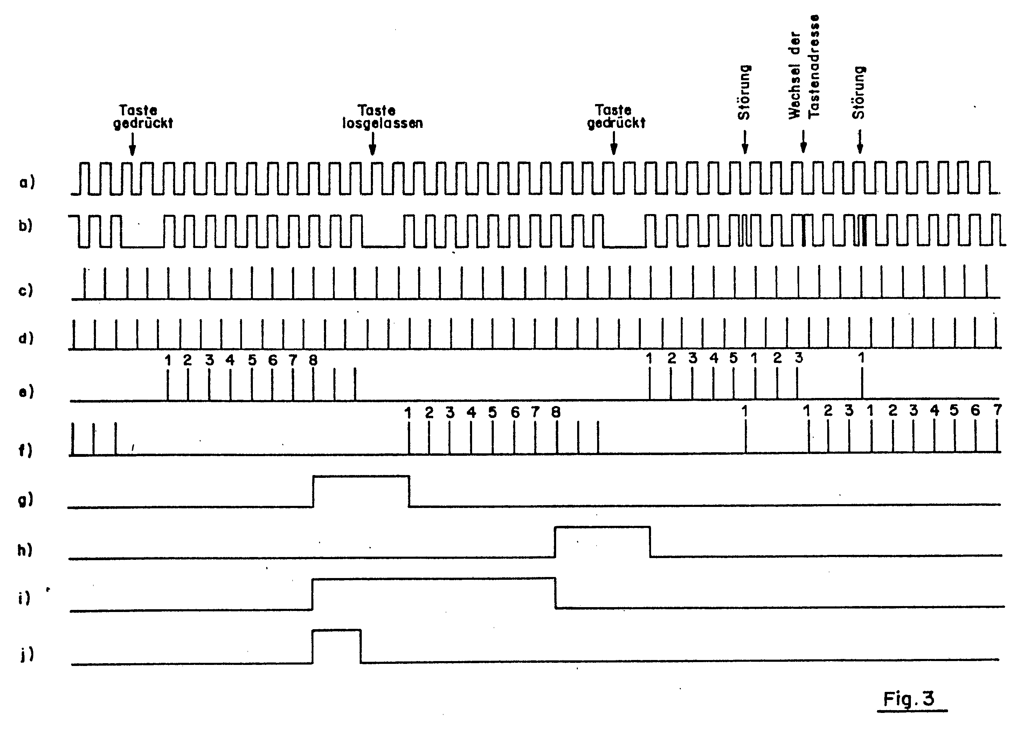

Eine Ausführungsform des in Zusammenhang mit Fig. 1 erläuterten Prinzips soll nun anhand des Blockschemas von Fig. 2 und des zugehörigen Impulsdiagramms in Fig. 3 beschrieben werden. Die Schaltung nach Fig. 2 weist eine Trafomatrix 11 mit vier Zeilen und acht Kolonnen, also total 32 Tasten mit den zugehörigen Tastentransformatoren sowie einem Kompensationstransformator 12 auf.

Mit Vorteil weisen die Primär- und Sekundärwicklungen jedes Tastentransformators nur je eine Windung auf, wobei sich eine der Wicklungen auf der Vorderseite und die andere auf der Rückseite einer doppelseitig beschichteten, gedruckten Schaltungsplatte befindet. Dabei wird, um zu einer einfachen Serienschaltung zu gelangen, jede Windung einer Wicklung in zwei Halbwindungen aufgeteilt, wobei die einen Halbwindungen einer Zeile oder Kolonne jeweils mit den andern Halbwindungen dieser Zeile oder Kolonne in Reihe geschaltet sind und so eine Schleife bilden. In Fig. 2 sind diese Schleifen nur durch gerade Linien angedeutet. Die Primärwicklungen dieser Transformatoren werden zeilenweise durch einen Sinusgenerator 15 über ein Anschaltglied 13 in Form eines Decoders 1-aus-4 mit nachgeschalteten Verstärkern 13' mit einem Sinussignal gespeist. Der Sinusgenerator 15 wird durch einen für die ganze Schaltung gemeinsamen Taktgenerator 16 mit dem in Fig. 3a gezeigten Signal angesteuert. Die Sekundärwicklungen dieser Transformatoren werden kolonnenweise über ein Wahlglied 14 in Form eines Analog-Multiplexers an eine aus den logischen Schaltungen 19-29 bestehende Auswerteschaltung angeschaltet. Die Steuerung des Decoders 13 und des Multiplexers 14 wird durch einen Adresszähler 17 ausgeführt, welcher sein Fortschaltsignal vom Taktgenerator 16 über ein UND-Tor 18 mit zwei Eingängen erhält, an dessen anderem Eingang ein Freigabesignal der Auswerteschaltung solange anliegt, bis die letztere eine betätigte Taste detektiert hat. Daraufhin wechselt das Freigabesignal seinen logischen Zustand und der Zähler 17 bleibt solange auf der der Adresse der betätigten Taste entsprechenden Stellung stehen, als die Taste betätigt bleibt. Diese Tastenadresse kann durch einen Leseimpuls auf Leitung 30 entweder direkt oder nach Umrechnung in einem Festwertspeicher 31, z. B. in den bei Tastaturen üblichen ASCII-Code, in eine nachgeschaltete, nicht gezeigte Nutzvorrichtung eingegeben werden.

Hauptbestandteile der Auswerteschaltung sind zwei UND-Tore 19 und 20 mit je zwei Eingängen. An je einem der Eingänge erscheint das durch einen Verstärker 24 und eine nachgeschaltete Schmitt-Trigger-Schaltung 25 in ein Impulssignal gemäss Fig. 3b umgeformte Ausgangssignal der Trafomatrix. Am zweiten Eingang von Tor 19 erscheint ein in einem monostabilen Multivibrator 21 aus dem Taktsignal abgeleitetes erstes Abtastsignal gemäss Fig. 3c, während am zweiten Eingang von Tor 20 ein in einem monostabilen Multivibrator 22 mit vorgeschalteten Inverter vom Taktsignal abgeleitetes zweites Abtastsignal gemäss Fig. 3d erscheint, das gegenüber dem ersten Abtastsignal eine Phasenverschiebung von 180° aufweist.

Die Phasenlage des Signales von Generator 15 zu jener des Taktsignales von Generator 16 ist so gewählt, dass das Ausgangssignal einer betätigten Taste phasengleich mit dem ersten Abtastsignal und das Ausgangssignal einer nichtbetätigten Taste phasengleich mit dem zweiten Abtastsignal ist.

Bei betätigter Taste erscheint also am Ausgang von UND-Tor 19 ein Impulssignal, das in Fig. 3e gezeigt ist, während bei unbetätigter Taste am Ausgang von UND-Tor 20 ein Impulssignal erscheint, das in Fig. 3f gezeigt ist. Der Ausgang von Tor 19 ist mit dem Zähleingang eines durch 8 teilenden Zählers 26 und mit dem Rückstelleingang eines ebenfalls durch 8 teilenden Zählers 27 verbunden. Der Ausgang von Tor 20 ist mit dem Zähleingang des Zählers 27 und mit dem Rückstelleingang des Zählers 26 verbunden. Der Ausgang des Zählers 26 ist mit dem Setzeingang und der Ausgang des Zählers 27 mit dem Rückstelleingang eines RS-Flip-Flops 28 verbunden, dessen nichtinvertierter Ausgang Q mit dem Eingang eines monostabilen Multivibrators 29 verbunden ist, an dessen Ausgang der bereits erwähnte Adressenleseimpuls auf Leitung 30 abgegeben wird, welcher in Fig. 3j sichtbar ist. Die Ausgangssignale der Zähler 26 und 27 sowie jenes des Flip-Flops 28 sind in den Fig. 3g, 3h bzw. 3i sichtbar.

Der Zustand des Flip-Flops 28 gibt an, ob die zuletzt angeschaltete Taste betätigt war oder nicht. Ein Signal mit dem logischen Pegel « 1» am Ausgang Q von FF28 gibt an, dass eine Taste als betätigt erkannt wurde, wobei das gleichzeitig am Ausgang Q erscheinende Signal mit dem logischen Pegel « O » das bereits erwähnte UND-Tor 18 am Eingang des Adressenzählers 17 sperrt.

Wie bereits erwähnt wurde, erscheint bei betätigter Taste ein Impulssignal am Ausgang des UND-Tores 19, dessen erster Impuls zum Setzen von FF28 benützt werden könnte, während der erste Impuls am Ausgang des UND-Tores 20 nach Loslassen der Taste zum Rückstellen von FF28 verwendet werden könnte.

Tatsächlich gelangen diese Signale an die Zähl- bzw. Rückstelleingänge der beiden Zähler 26 und 27. Da beide Zähler durch 8 teilen, sind jeweils 8 Impulse am Zähleingang nötig, bis der Ausgang Q des entsprechenden Zählers auf den logischen Pegel « 1 » geht. Weil die Ausgänge beider UND-Tore 19 und 20 sowohl mit dem Zähleingang des zugehörigen wie auch mit dem Rückstelleingang des jeweils anderen Zählers verbunden sind und die Zählerrückstellung bereits beim ersten am Rückstelleingang eintreffenden Impuls erfolgt, ergibt sich die Bedingung, dass jeder Zähler nur dann seine Endstellung erreicht und damit ein Signal an FF28 abgibt, wenn mindestens acht unmittelbar aufeinanderfolgende Vergleiche das gleiche Resultat ergeben.

Diese Bedingung· ergibt eine sehr hohe Störsicherheit der Tastatur. Tritt z. B. ein gegenphasiger Störimpuls kurz nach Drücken einer Taste auf, d. h. noch vor deren Erkennung als gedrückte Taste, wie dies in Fig. 3 rechts angedeutet ist, so wird der Zähler 26 (Fig. 3e) zurückgestellt und der Zähler 27 zählt einen Impuls (Fig. 3f), dann beginnt Zähler 26 wieder neu zu zählen, kann aber wegen vorzeitigen Wechsels der Tastenadresse nicht bis acht zählen, d. h. de Adresszähler macht einen Umlauf, bis diese Taste als gedrückt erkannt werden kann. Aehnliches geschieht beim Loslassen einer Taste. Damit eine falsche Ausgabe entstehen könnte, müssten also unmittelbar hintereinander acht Störimpulse mit entsprechender Phase und Taktfrequenz und einer Amplitude, welche die jeweilige Ausgangsspannung der Trafomatrix 11 um die Ansprechschwelle der Impulsformerschaltung 24, 25 übersteigt, auftreten.

Der Umstand, dass die Amplitude der Ausgangsspannung der Trafomatrix beim Betätigen und Loslassen einer Taste jeweils durch Null läuft (Gleichheit der Amplituden der Ausgangsspannungen von Tastentransformator und Kompensationstransformator) und dass die Impulsformerschaltung 24, 25 eine Ansprechschwelle aufweist, bewirken eine eindeutige Hysterese im Tastenhub, für welchen eine Taste als gedrückt bzw. als losgelassen erkannt werden kann, wobei die obgenannte Zählbedingung diese Hysterese relativ unabhängig von Bauelementestreuungen macht. Es kann daher auch bei extrem langsamer Tastenbetätigung niemals ein Flattern eines Zeichens auftreten. Die Hysterese und die Zählbedingung ergeben gleichzeitig einen guten Schutz gegen eine ungewollte Doppelausgabe eines Zeichens.

Da der den Decoder 13 und den Multiplexer 14 ansteuernde Adresszähler 17 und die Auswerteschaltung mit den Elementen 19 bis 29 mit dem gleichen Taktsignal vom Generator 16 versorgt werden, muss der Adresszähler 17 mindestens solange auf einer Adresse verharren, dass einer der Zähler 26 oder 27 acht Impulse zählen kann. Um dies zu erreichen, sind die ersten drei Ausgänge des Zählers 17, der als mehrstufiger Binärzähler ausgelegt ist, nicht angeschlossen, so dass sich eine Untersetzung 1 : 16 für den ersten angeschlossenen Ausgang ergibt. Dies erlaubt neben der Möglichkeit, dass einer der Zähler 26 oder 27 auf acht zählen kann, noch einen gewissen Freiraum für Einschwingvorgänge beim Betätigen einer Taste.

Bei einer angenommenen Taktfrequenz von 1 Mhz ergibt sich eine Maximalfrequenz von 62,5 kHz für den Wechsel der Tastenadresse bzw. eine Repetitionsfrequenz von ca. 2 kHz für die Abfrage einer bestimmten Taste bei einem Tastenfeld von 32 Tasten. Dies bedeutet, dass eine Taste spätestens nach 0,5 ms als gedrückt oder losgelassen erkannt wird.

Es ist klar, dass durch andere Auslegung der Zähler 26 und 27 und entsprechende Auslegung des Adressenzählers 17 die Anzahl der Taktimpulse bzw. Vergleiche verändert werden kann, die man als Beweis einer Tastenbetätigung haben will.

Da, wie bereits erwähnt, das am Ausgang $\overline{Q}$ von FF28 bei Detektion einer betätigten Taste erscheinende Signal mit dem logischen Pegel « 0 » über das UND-Tor 18 den Adresszähler 17 solange anhält, bis nach Loslassen dieser Taste der Zähler 27 acht Impulse gezählt hat, ist sichergestellt, dass das simultane Betätigen mehrerer Tasten weder zu einer Fehlinterpretation, noch zu einer Blockierung der Tastatur führt, sondern es wird nur die zuerst gedrückte Taste als solche interpretiert. Dagegen ist ein gleitender Uebergang von einer Taste zu einer andern möglich, weil der Adresszähler nach Loslassen der zuerst gedrückten Taste wieder weiterläuft bis zur nächsten gedrückten Taste, deren gedrückter Zustand auf Grund der Phasenlage ihres Ausgangssignales detektiert werden kann. Da die Detektion des Zustandes einer Taste auf der Detektion der Phasenlage ihres Ausgangssignales basiert, hat die Geschwindigkeit der Tastenbetätigung keinen Einfluss auf das Ergebnis der Detektion, d. h., es erfolgt eine statische Detektion des Zustandes und nicht eine dynamische Detektion der Zustandsänderung. Dies hat zur Folge, dass die mechanische Auslegung der Tastatur ziemlich frei erfolgen kann, z. B. mit oder ohne Druckpunkt, je nach den Forderungen des Anwenders.

Wie bereits mehrfach erwähnt wurde, bewirkt der Kompensationstransformator 2 von Fig. 1 bzw. 12 von Fig. 2 eine Ueberkompensation des Leerlaufsignales des jeweils angeschalteten, unbetätigten Tastentransformators. Beim Einschieben eines Tastenkerns geht die Amplitude des an die Auswerteschaltung gelangenden Signales durch 0, wie dies aus Fig. 3b sichtbar ist, um beim weitern Einschieben wieder anzusteigen, jedoch mit um 180° gedrehter Phase.

Dieser Umstand kann ausgenützt werden für eine einfache Einstellung des für ein Ansprechen der Auswerteschaltung notwendigen Tastenhubes. Wenn man die Grösse der Ueberkompensation einstellbar macht, in dem man z. B. den Kompensationstransformator mit einem mechanisch, z. B. mit Hilfe einer Schraube, verstellbaren Kern versieht, wird gleichzeitig mit dem Verstellen dieses Kernes für alle Tasten der Tastenhub verstellt, der notwendig ist, bis das Tastenausgangssignal das Kompensationssignal soweit übersteigt, dass am Ausgang von UND-Tor 19 Impulse erscheinen, die gezählt werden können für die Detektion der Tastenbetätigung, d. h. des Tastenhubes, für welchen die Taste als betätigt erkannt wird.

Die Verstellung des zum Ansprechen nötigen Tastenhubes kann so ausgelegt sein, dass sie dem Benützer der Tastatur jederzeit zugänglich ist, z. B. in Form eines Drehknopfes oder Rändelrades auf der Frontplatte. Es ist aber auch denkbar, diese Verstellmöglichkeit nur dem Fachmann bei der Herstellung oder beim Unterhalt der Tastatur zugänglich zu machen.

**Patentansprüche**

1. Kontaktlose Tastatur mit je einem Transformator (1) pro Taste mit einem durch die Betätigung der Taste verschiebbaren Tauchkern (7), bei welcher Iastatur die Iastentransformatoren in Matrixform zugeordnet sind und die Primärwicklungen einer Zeile (oder Kolonne) von Tastentransformatoren in Serie mit der Primärwicklung eines keiner Taste zugeordneten Kompensationstransformators (2) über ein Anschalteglied (3) an eine durch ein Taktsignal angesteuerte Wechselstromquelle (5) und die Sekundärwicklungen einer Kolonne (oder Zeile) in Serie mit der Sekundärwicklung des Kompensationstransformators über ein Wahlglied (4) an eine Auswerteschaltung (6) anschaltbar sind, dadurch gekennzeichnet, dass der Kompensationstransformator (2) so ausgelegt ist, dass die Sekundärspannung des jeweiligen durch das Anschalteglied (3) und das Wahlglied (4) aktiv geschalteten Tastentransformators (1) bei unbetätigter Taste überkompensiert ist, so dass bei Betätigung der Taste eine Phasendrehung im Signal an die Auswerteschaltungerfolgt, und dass die Auswerteschaltung (6) Vergleichsmittel aufweist, um die Phase des auszuwertenden Signales mit jener eines Bezugssignales zu vergleichen.

2. Tastatur nach Anspruch 1, dadurch gekennzeichnet, dass die Phasenvergleichsmittel Zählmittel (26, 27) aufweisen, welche erst nach einer bestimmten Anzahl aufeinanderfolgender Vergleiche mit gleichem Resultat ein Ausgangssignal abgeben.

3. Tastatur nach Anspruch 2, dadurch gekennzeichnet, dass die Phasenvergleichsmittel zwei UND-Tore (19, 20) mit je zwei Eingängen aufweisen, von denen der jeweils eine das durch eine Impulsformerschaltung (24, 25) umgeformte Ausgangssignal des Wahlgliedes (14) und der jeweils andere das Taktsignal bzw. das invertierte Taktsignal eines Taktgenerators (16) erhält.

4. Tastatur nach Anspruch 3, dadurch gekennzeichnet, dass der Ausgang eines ersten der genannten UND-Tore (19) mit dem Zähleingang eines ersten Zählers (26) und mit dem Rückstelleingang eines zweiten Zählers (27) verbunden ist, und dass der Ausgang des zweiten UND-Tores (20) mit dem Zähleingang des zweiten Zählers (27) und mit dem Rückstelleingang des ersten Zählers (26) verbunden ist.

5. Tastatur nach Anspruch 4, dadurch gekennzeichnet, dass der Ausgang des ersten Zählers (26) mit dem Setzeingang (S) und der Ausgang des zweiten Zählers (27) mit dem Rückstelleingang (R) eines RS-Flip-Flops (28) verbunden ist, dessen Ausgangssignal angibt, ob die durch das Anschalteglied (13) und das Wahlglied (14) ausgewählte Taste betätigt ist oder nicht.

6. Tastatur nach Anspruch 5, dadurch gekennzeichnet, dass das Anschalteglied (13) und das Wahlglied (14) mit Ausgängen eines Adresszählers (17) verbunden sind, welcher das Taktsignal der Quelle (16) als Fortschaltesignal über ein UND-Tor (18) mit zwei Eingängen erhält, dessen zweiter Eingang mit dem invertierten Ausgang ($\overline{Q}$) des RS-Flip-Flops (28) verbunden ist, so dass die Weiterschaltung des Zählers stoppt, wenn das Flip-Flop in den Zustand kippt, der einer betätigten Taste entspricht, wobei der Zählstand des Adresszählers (17) die Adresse der betätigten Taste (11) angibt.

7. Tastatur nach Anspruch 6, dadurch gekennzeichnet, dass ein Umrechner (31) mit den für die Anschaltung und die Auswahl verwendeten Ausgängen des Adresszählers (17) verbunden ist, um die durch den Zählstand gegebene Tastenadresse in einen für Tastaturen üblichen Code umzurechnen.

8. Tastatur nach Anspruch 1, dadurch gekennzeichnet, dass der Kompensationstransformator (12) mit einem Tauchkern versehen ist, dessen Eintauchtiefe mit mechanischen Mitteln verstellbar ist, um das Ausmass der Ueberkompensation und damit den für das Ansprechen der Auswerteschaltung auf eine Tastenbetätigung notwendigen Tastenhub für alle Tasten (11) gemeinsam zu verstellen.

9. Tastatur nach Anspruch 8, dadurch gekennzeichnet, dass die mechanischen Mittel zur Verstellung der Eintauchtiefe des Kerns des Kompensationstransformators (12) aus einer Schraube mit zugehöriger Mutter bestehen.

10. Tastatur nach Anspruch 8, dadurch gekennzeichnet, dass die mechanischen Mittel zur Verstellung der Eintauchtiefe des Kerns des Kompensationstransformators (12) einen Exzenter aufweisen, der auf einen federbelasteten Tauchkern einwirkt.

11. Tastatur nach Anspruch 9 oder 10, dadurch gekennzeichnet, dass die Mittel zur Verstellung der Eintauchtiefe des Kerns dem Benützer der Tastatur frei zugänglich sind.

**Claims**

1. Contactless keyboard comprising for each key a transformer (1) provided with a movable plunger type core (7) wherein the key transformers are allocated matrix-like and the primary windings of a row (or column) of key transformers can be connected in series with the primary winding of a compensation transformer (2) not allocated to any of the keys via a connecting member (3) to an AC-source (5) controlled by a clock signal and the secondary windings of a column (or row) can be connected in series with the secondary winding of the compensation transformer via a selecting member (4) to an evaluation circuit (6), characterized in that the compensation transformer (2) is so designed that the secondary voltage of a key transformer rendered active via the connecting member (3) and the selecting member (4) is overcompensated with released key so that with the actuation of the key the signal at the evaluation circuit performs a phase shift, and that the evaluation circuit (6) is provided with comparison means comparing the phase of the signal to be evaluated with that of a reference signal.

2. Keyboard according to claim 1, characterized in that the phase comparison means comprise counting means (26, 27) which deliver an output signal only after a distinct number of successive comparison operations giving the same result.

3. Keyboard according to claim 2, characterized in that the phase comparison means comprise two AND-gates (19, 20) each having two inputs the respective one of which receives the output signal of the selection member (14) shaped by a pulseformer circuit (24, 25) and the respective other of which receives the clock signal or the inverted clock signal of a clock generator (16).

4. Keyboard according to claim 3, characterized in that the output of the first one of said AND-gates (19) is connected to the counting input of a first counter (26) and to the reset input of a second counter (27), and that the output of the second AND-gate (20) is connected to the counting input of the second counter (27) and to the reset input of the first counter (26).

5. Keyboard according to claim 4, characterized in that the output of the first counter (26) is connected to the set input (S) and the output of the second counter (27) is connected to the reset input (R) of an RS-flip-flop (28) the output of which indicates whether the key selected by the connecting member (13) and the selecting member (14) is depressed or not.

6. Keyboard according to claim 5, characterized in that the connecting member (13) and the selecting member (14) are connected to the outputs of an address counter (17) which reveices the clock signal of the source (16) as a stepping signal via an AND-gate (18) having two inputs the second input of which is connected to the inverted output ($\overline{Q}$) of the RS-flip-flop (28) so that the stepping of the counter is inhibited when the flip-flop goes into the condition corresponding to a depressed key whereby the count of the address counter (17) indicates the address of the depressed key (11).

7. Keyboard according to claim 6, characterized in that a translator (31) is connected to the outputs of the address counter (17) used for connecting and selecting in order to translate the key address given by the count into a code generally used for keyboards.

8. Keyboard according to claim 1, characterized in that the compensation transformer (12) is provided with a plunger type core the penetration depth of which is adjustable by mechanical means in order to adjust for all keys (11) in common the amount of overcompensation and therewith the key stroke needed for a response of the evaluation circuit to the actuation of a key.

9. Keyboard according to claim 8, characterized in that the mechanical means for adjusting the penetration depth of the core of the compensation transformer (12) consist of a screw and a nut.

10. Keyboard according to claim 8, characterized in that the mechanical means for adjusting the penetration depth of the core of the compensation transformer (12) comprise an eccentric acting upon a spring loaded plunger type core.

11. Keyboard according to claim 9 or 10, characterized in that the means for adjusting the penetration depth of the core are accessible to the user of the keyboard.

**Revendications**

1. Clavier sans contact comportant, pour chaque touche, un transformateur (1) doté d'un noyau mobile du type noyau plongeur (7) déplaçable lors de l'actionnement de la touche, dans lequel les transformateurs des touches sont agencés sous forme de matrice, dans lequel les enroulements primaires d'une ligne (ou d'une colonne) de transformateurs de ligne peuvent être connectés, en série avec l'enroulement primaire d'un transformateur de compensation (2) affecté à aucune touche, à une source de courant alternatif (5) commandé par un signal de synchronisation, par l'intermédiaire d'un élément de connexion (3), et dans lequel les enroulements secondaires d'une colonne (ou d'une ligne) peuvent être connectés, en série avec l'enroulement secondaire du transformateur de compensation, à un circuit d'évaluation (6), par l'intermédiaire d'un élément de sélection (4), caractérisé en ce que le transformateur de compensation (2) est conçu pour que la tension secondaire d'un transformateur de touche (1) mis en circuit par l'élément de connexion (3) et par l'élément de sélection (4) soit surcompensée lorsque la touche n'est pas actionnée de sorte que, quand la touche est actionnée, il s'effectue une rotation de phase dans le signal envoyé dans le circuit d'évaluation, et en ce que le circuit d'évaluation (6) est équipé de moyens lui permettant de comparer la phase du signal à évaluer avec celle d'un signal de référence.

2. Clavier conforme à la revendication 1, caractérisé en ce que les moyens de comparaison de phase comprennent des moyens de comptage (26, 27) qui ne délivrent un signal de sortie qu'au terme d'un certain nombre de comparaisons successives ayant donné le même résultat.

3. Clavier conforme à la revendication 2, caractérisé en ce que les moyens de comparaison de phases comprennent deux portes ET (19, 20) comportant chacune deux entrées, dont l'une reçoit le signal de sortie de l'élément de sélection (14) traité par un circuit de mise en forme des impulsions (24, 25) et dont l'autre reçoit le signal de synchronisation ou le signal de synchronisation inversé d'un générateur d'horloge (16).

4. Clavier conforme à la revendication 3, caractérisé en ce que la sortie de la première des portes ET (19) indiquées est reliée à l'entrée de comptage d'un premier compteur (26) et à l'entrée de remise à zéro d'un second compteur (27), et en ce que la sortie de la seconde porte ET (20) est reliée à l'entrée de comptage du second compteur (27) et à l'entrée de remise à zéro du premier compteur (26).

5. Clavier conforme à la revendication 4, caractérisé en ce que la sortie du premier compteur (26) est reliée à l'entrée de positionnement (S) d'une bascule RS (28) et en ce que la sortie du second compteur (27) est reliée à l'entrée de remise à l'état initial (R) de ladite bascule dont le signal de sortie indique si la touche choisie par l'élément de connexion (13) et par l'élément de sélection (14) est actionnée ou non.

6. Clavier conforme à la revendication 5, caractérisé en ce que l'élément de connexion (13) et l'élément de sélection (14) sont reliés aux sorties d'un compteur d'adresses (17) qui reçoit le signal de synchronisation du générateur (16), sous la forme d'un signal de progression, par l'intermédiaire d'une porte ET (18) à deux entrées, dont la seconde entrée est reliée à la sortie inversée ($\overline{Q}$) de la bascule RS (28), de sorte que le compteur ne progresse plus lorsque la bascule se trouve dans l'état correspondant à une touche actionnée, la position du compteur d'adresses (17) indiquant l'adresse de la touche actionnée (11).

7. Clavier conforme à la revendication 6, caractérisé en ce qu'un convertisseur (31) est relié aux sorties du compteur d'adresses (17) utilisées pour la connexion et la sélection, afin de convertir l'adresse de la touche indiquée par la position du compteur en un code habituel de clavier.

8. Clavier conforme à la revendication 1, caractérisé en ce que le transformateur de compensation (12) est muni d'un noyau plongeur dont la profondeur de plongée est réglable par des moyens mécaniques, afin de régler pour l'ensemble des touches (11) le niveau de la surcompensation et donc la course de touche nécessaire pour solliciter le circuit d'évaluation lors d'un actionnement de touche.

9. Clavier conforme à la revendication 8, caractérisé en ce que les moyens mécaniques permettant de régler la profondeur de plongée du noyau du transformateur de compensation (12) se composent d'une vis et de son écrou.

10. Clavier conforme à la revendication 8, caractérisé en ce que les moyens mécaniques permettant de régler la profondeur de plongée du noyau du transformateur de compensation (12) comportent un excentrique agissant sur un noyau plongeur chargé par un ressort.

11. Clavier conforme à la revendication 9 ou 10, caractérisé en ce que les moyens permettant de régler la profondeur de plongée du noyau sont librement accessibles à l'utilisateur du clavier.

Fig. 1

Fig. 2

Fig. 3

0 043 350